# EUROPEAN PATENT SPECIFICATION

(11) **EP 1 811 570 B1**
(45) Date of publication and mention of the grant of the patent: **25.11.2020**
(21) Application number: 07250267.7
(22) Date of filing: 23.01.2007
(51) Int. Cl.: H01L 27/32, H01L 51/52

(54) **Organic light emitting display and method of fabricating the same**
Organische lichtemittierende Anzeigevorrichtung und Herstellungsverfahren
Dispositif d'affichage électroluminescent organique et méthode de fabrication

(30) Priority: 23.01.2006 KR 20060007025; 25.01.2006 KR 20060007962; 27.03.2006 KR 20060027321
(43) Date of publication of application: 25.07.2007
(73) Proprietor: Samsung Display Co., Ltd., Gyeonggi-do (KR)
(72) Inventor: Choi, Dong-Soo, c/o Samsung SDI Co. Ltd., Suwon-si Gyeonggi-do (KR); Park, Jin-Woo, c/o Samsung SDI Co. Ltd., Suwon-si Gyeonggi-do (KR)
(74) Representative: Mounteney, Simon James

(56) References cited:
- EP-A2- 1 503 422
- EP-A2- 1 575 090
- JP-A- H1 074 583
- JP-A- 10 074 583
- US-A1- 2004 207 314
- US-A1- 2005 195 355

## Description

### BACKGROUND OF THE INVENTION

### Field of the Invention

The present invention relates to organic light emitting display devices. More particularly, the present invention relates to packaging organic light emitting display devices.

### Description of the Related Art

With the goal of improving upon the shortcomings of conventional displays such as cathode ray tubes, attention has recently been focused on flat panel displays such as liquid crystal displays, organic light emitting displays, plasma display panels (PDP), and so on.

Since the liquid crystal display is a passive device rather than an emissive device, it is difficult to make having high brightness and contrast, a wide viewing angle, and a large-sized screen. While the PDP is an emissive device, it is heavy, consumes much power, and requires a complex manufacturing process, compared to other displays.

Meanwhile, since the organic light emitting display (OLED) is an emissive device, it has a wide viewing angle, and high contrast. In addition, since it does not require a backlight, it can be made lightweight, compact, and power efficient. Further, the OLED can be driven at a low DC voltage, has a rapid response speed, and is formed entirely of solid material. As a result, the OLED has the ability to withstand external impact and a wide range of temperatures, and can be fabricated by a simple method at low cost.

US 2005195355 A1 discloses a flat display device including a display region, for displaying an image, between a first substrate and a second substrate. The flat display device includes a sealant adhering the first substrate to the second substrate, one or more interconnection lines between the sealant and the first substrate, and a covering film between the sealant and the interconnection lines.

EP1575090 A2 discloses an electroluminescent display device that includes a display area formed on one surface of a substrate, and a first electrode layer, a second electrode layer, and an electroluminescent emission layer between the first and second electrode layers. It also includes an electrode power supply line that supplies electrode power to the display area.

JP10074583 discloses a cathode arranged in a stripe shape on a first transparent substrate, and a white light emitting body formed on the cathode in a display region. The cathode and an anode are arranged so as to cross each other in a matrix pattern. A second transparent substrate faces the first substrate. The first and second substrates are sealed with frit.

US2004207314 A1 discloses a hermetically sealed glass package and method for manufacturing the hermetically sealed glass package are described herein using an OLED display as an example. The hermetically sealed OLED display is manufactured by providing a first substrate plate and a second substrate plate and depositing a frit onto the second substrate plate. OLEDs are deposited on the first substrate plate. An irradiation source (e.g., laser, infrared light) is then used to heat the frit which melts and forms a hermetic seal that connects the first substrate plate to the second substrate plate.

EP1503422 A2 discloses a flat panel display including a display region formed on a substrate and a sealing member by which edges of a covering member are bonded to the substrate to seal at least the display region, and a driving power supply line arranged in such a way that at least a part of the driving power supply line is positioned between the sealing member and the substrate.

### SUMMARY OF CERTAIN INVENTIVE ASPECTS

According to a first aspect of the invention, there is provided an organic light emitting device as set out in Claim 1. Preferred features of this aspect are set out in claims 2 to 15.

According to a second aspect of the invention, there is provided a method of making an organic light emitting device as set out in Claim 16. Preferred features of this aspect are set out in claims 17 to 25.

### BRIEF DESCRIPTION OF THE DRAWINGS

Embodiments of the present invention will be described by way of example and with reference to the attached drawings in which:
FIG. 1 is a cross-sectional view of an organic light emitting display not according to the invention;
FIGS. 2 to 5 are cross-sectional views of an organic light emitting display not according to the invention;
FIG. 6 is a cross-sectional view of an organic light emitting display in accordance with the invention;
FIG. 7A is a schematic exploded view of a passive matrix type organic light emitting display device.
FIG 7B is a schematic exploded view of an active matrix type organic light emitting display device.
FIG. 7C is a schematic top plan view of an organic light emitting display.
FIG. 7D is a cross-sectional view of the organic light emitting display of FIG. 7C, taken along the line d-d.
FIG. 7E is a schematic perspective view illustrating mass production of organic light emitting devices.

### DETAILED DESCRIPTION

The present invention will now be described more fully hereinafter with reference to the accompanying drawings, in which some embodiments of the invention are shown. This invention may, however, be embodied in different forms and should not be construed as limited to the embodiments set forth herein. Rather, these embodiments are provided so that this disclosure will be thorough and complete, and will fully convey the scope of the invention as claimed to those skilled in the art. In the drawings, the thickness of layers and regions may be exaggerated for clarity. Like reference numerals designate like elements throughout the specification.

An organic light emitting display (OLED) is a display device comprising an array of organic light emitting diodes. Organic light emitting diodes are solid state devices which include an organic material and are adapted to generate and emit light when appropriate electrical potentials are applied.

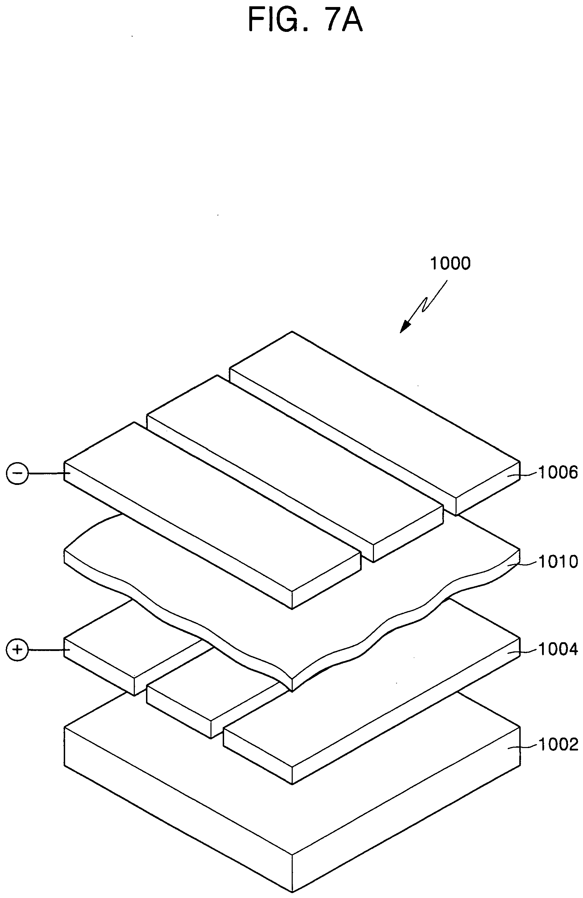

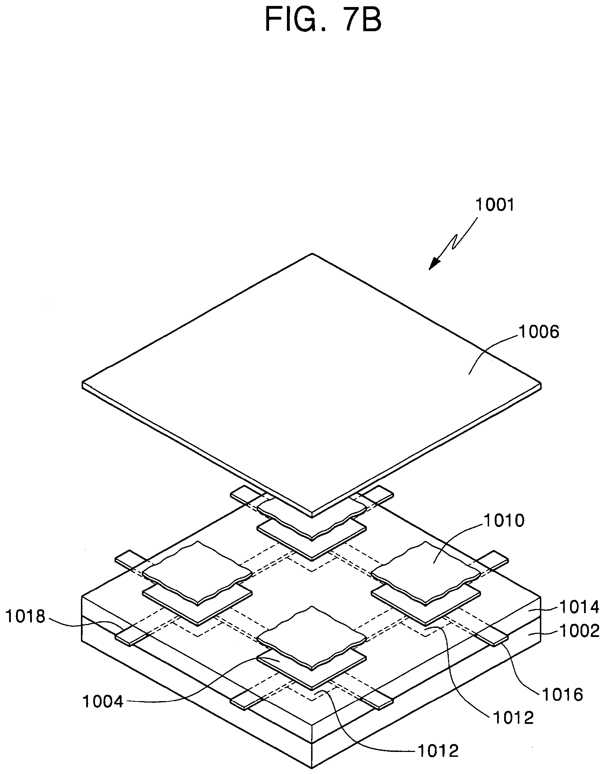

OLEDs can be generally grouped into two basic types dependent on the arrangement with which the stimulating electrical current is provided. Fig. 7A schematically illustrates an exploded view of a simplified structure of a passive matrix type OLED 1000. Fig. 7B schematically illustrates a simplified structure of an active matrix type OLED 1001. In both configurations, the OLED 1000, 1001 includes OLED pixels built over a substrate 1002, and the OLED pixels include an anode 1004, a cathode 1006 and an organic layer 1010. When an appropriate electrical current is applied to the anode 1004, electric current flows through the pixels and visible light is emitted from the organic layer.

Referring to Fig. 7A, the passive matrix OLED (PMOLED) design includes elongate strips of anode 1004 arranged generally perpendicular to elongate strips of cathode 1006 with organic layers interposed therebetween. The intersections of the strips of cathode 1006 and anode 1004 define individual OLED pixels where light is generated and emitted upon appropriate excitation of the corresponding strips of anode 1004 and cathode 1006. PMOLEDs provide the advantage of relatively simple fabrication.

Referring to Fig. 7B, the active matrix OLED (AMOLED) includes driving circuits 1012 arranged between the substrate 1002 and an array of OLED pixels. An individual pixel of AMOLEDs is defined between the common cathode 1006 and an anode 1004, which is electrically isolated from other anodes. Each driving circuit 1012 is coupled with an anode 1004 of the OLED pixels and further coupled with a data line 1016 and a scan line 1018. In use, the scan lines 1018 supply select signals that select rows of the driving circuits, and the data lines 1016 supply data signals for particular driving circuits. The data signals and scan signals stimulate the local driving circuits 1012, which excite the anodes 1004 so as to emit light from their corresponding pixels.

In the illustrated AMOLED, the local driving circuits 1012, the data lines 1016 and scan lines 1018 are buried in a planarization layer 1014, which is interposed between the pixel array and the substrate 1002. The planarization layer 1014 provides a planar top surface on which the organic light emitting pixel array is formed. The planarization layer 1014 may be formed of organic or inorganic materials, and formed of two or more layers although shown as a single layer. The local driving circuits 1012 are typically formed with thin film transistors (TFT) and arranged in a grid or array under the OLED pixel array. The local driving circuits 1012 may be at least partly made of organic materials, including organic TFT.

AMOLEDs have the advantage of fast response time improving their desirability for use in displaying data signals. Also, AMOLEDs have the advantages of consuming less power than passive matrix OLEDs.

Referring to common features of the PMOLED and AMOLED designs, the substrate 1002 provides structural support for the OLED pixels and circuits. In various arrangements, the substrate 1002 can comprise rigid or flexible materials as well as opaque or transparent materials, such as plastic, glass, and/or foil. As noted above, each OLED pixel or diode is formed with the anode 1004, cathode 1006 and organic layer 1010 interposed therebetween. When an appropriate electrical current is applied to the anode 1004, the cathode 1006 injects electrons and the anode 1004 injects holes. In certain structures, the anode 1004 and cathode 1006 are inverted; i.e., the cathode is formed on the substrate 1002 and the anode is opposingly arranged.

Interposed between the cathode 1006 and anode 1004 are one or more organic layers. More specifically, at least one emissive or light emitting layer is interposed between the cathode 1006 and anode 1004. The light emitting layer may comprise one or more light emitting organic compounds. Typically, the light emitting layer is configured to emit visible light in a single color such as blue, green, red or white. In the illustrated configuration, one organic layer 1010 is formed between the cathode 1006 and anode 1004 and acts as a light emitting layer. Additional layers, which can be formed between the anode 1004 and cathode 1006, can include a hole transporting layer, a hole injection layer, an electron transporting layer and an electron injection layer.

Hole transporting and/or injection layers can be interposed between the light emitting layer 1010 and the anode 1004. Electron transporting and/or injecting layers can be interposed between the cathode 1006 and the light emitting layer 1010. The electron injection layer facilitates injection of electrons from the cathode 1006 toward the light emitting layer 1010 by reducing the work function for injecting electrons from the cathode 1006. Similarly, the hole injection layer facilitates injection of holes from the anode 1004 toward the light emitting layer 1010. The hole and electron transporting layers facilitate movement of the carriers injected from the respective electrodes toward the light emitting layer.

In some devices, a single layer may serve both electron injection and transportation functions or both hole injection and transportation functions. In some cases, one or more of these layers are lacking. In some structures, one or more organic layers are doped with one or more materials that help injection and/or transportation of the carriers. In cases where only one organic layer is formed between the cathode and anode, the organic layer may include not only an organic light emitting compound but also certain functional materials that help injection or transportation of carriers within that layer.

There are numerous organic materials that have been developed for use in these layers including the light emitting layer. Also, numerous other organic materials for use in these layers are being developed. In some configurations, these organic materials may be macromolecules including oligomers and polymers. In some instances, the organic materials for these layers may be relatively small molecules. The skilled artisan will be able to select appropriate materials for each of these layers in view of the desired functions of the individual layers and the materials for the neighboring layers in particular designs.

In operation, an electrical circuit provides appropriate potential between the cathode 1006 and anode 1004. This results in an electrical current flowing from the anode 1004 to the cathode 1006 via the interposed organic layer(s). In one arrangement, the cathode 1006 provides electrons to the adjacent organic layer 1010. The anode 1004 injects holes to the organic layer 1010. The holes and electrons recombine in the organic layer 1010 and generate energy particles called "excitons." The excitons transfer their energy to the organic light emitting material in the organic layer 1010, and the energy is used to emit visible light from the organic light emitting material. The spectral characteristics of light generated and emitted by the OLED 1000, 1001 depend on the nature and composition of organic molecules in the organic layer(s). The composition of the one or more organic layers can be selected to suit the needs of a particular application by one of ordinary skill in the art.

OLED devices can also be categorized based on the direction of the light emission. In one type referred to as a "top emission" type, OLED devices emit light and display images through the cathode or top electrode 1006. In these devices, the cathode 1006 is made of a material transparent or at least partially transparent with respect to visible light. In certain structures, to avoid losing any light that can pass through the anode or bottom electrode 1004, the anode may be made of a material substantially reflective of the visible light. A second type of OLED device emits light through the anode or bottom electrode 1004 and is called a "bottom emission" type. In the bottom emission type OLED devices, the anode 1004 is made of a material which is at least partially transparent with respect to visible light. Often, in bottom emission type OLED devices, the cathode 1006 is made of a material substantially reflective of the visible light. A third type of OLED device emits light in two directions, e.g. through both anode 1004 and cathode 1006. Depending upon the direction(s) of the light emission, the substrate may be formed of a material which is transparent, opaque or reflective of visible light.

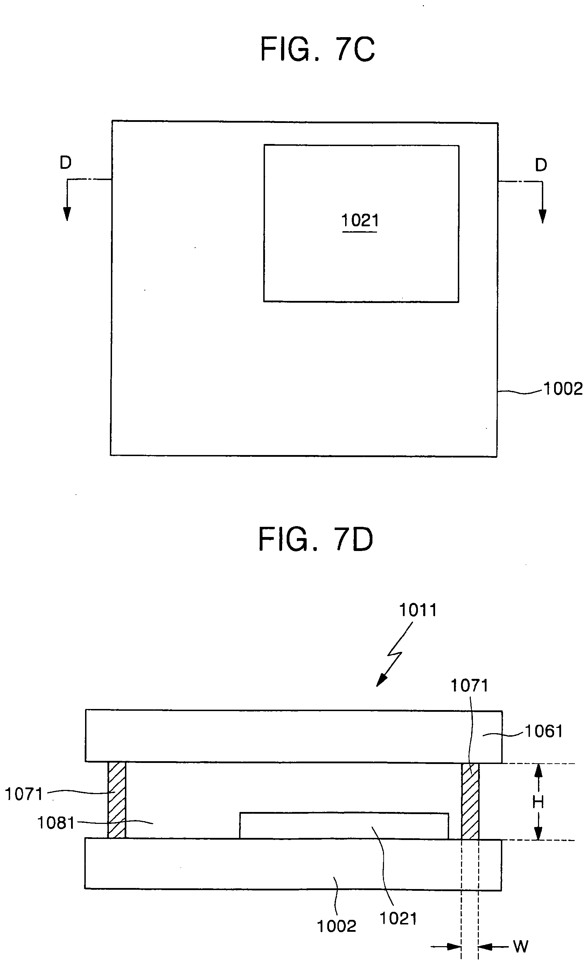

In many cases, an OLED pixel array 1021 comprising a plurality of organic light emitting pixels is arranged over a substrate 1002 as shown in Fig. 7C. The pixels in the array 1021 are then controlled to be turned on and off by a driving circuit (not shown), and the plurality of the pixels as a whole displays information or image on the array 1021. In certain configurations, the OLED pixel array 1021 is arranged with respect to other components, such as drive and control electronics to define a display region and a non-display region. In these structures, the display region refers to the area of the substrate 1002 where OLED pixel array 1021 is formed. The non-display region refers to the remaining areas of the substrate 1002. The non-display region can contain logic and/or power supply circuitry. It will be understood that there will be at least portions of control/drive circuit elements arranged within the display region. For example, in PMOLEDs, conductive components will extend into the display region to provide appropriate potential to the anode and cathodes. In AMOLEDs, local driving circuits and data/scan lines coupled with the driving circuits will extend into the display region to drive and control the individual pixels of the AMOLEDs.

One design and fabrication consideration in OLED devices is that certain organic material layers of OLED devices can suffer damage or accelerated deterioration from exposure to water, oxygen or other harmful gases. Accordingly, it is generally understood that OLED devices be sealed or encapsulated to inhibit exposure to moisture and oxygen or other harmful gases found in a manufacturing or operational environment. Fig. 7D schematically illustrates a cross-section of an encapsulated OLED device 1011 having a layout of Fig. 7C and taken along the line d-d of Fig. 7C. In this device, a generally planar top plate or substrate 1061 engages with a seal 1071 which further engages with a bottom plate or substrate 1002 to enclose or encapsulate the OLED pixel array 1021. In other variations, one or more layers are formed on the top plate 1061 or bottom plate 1002, and the seal 1071 is coupled with the bottom or top substrate 1002, 1061 via such a layer. In the illustrated structure, the seal 1071 extends along the periphery of the OLED pixel array 1021 or the bottom or top plate 1002, 1061.

The seal 1071 is made of a frit material as will be further discussed below.

The top and bottom plates 1061, 1002 typically comprise materials such as plastics, glass and/or metal foils which can provide a barrier to passage of oxygen and/or water to thereby protect the OLED pixel array 1021 from exposure to these substances. At least one of the top plate 1061 and the bottom plate 1002 are typically formed of a substantially transparent material.

To lengthen the life time of OLED devices 1011, it is generally desired that seal 1071 and the top and bottom plates 1061, 1002 provide a substantially non-permeable seal to oxygen and water vapor and provide a substantially hermetically enclosed space 1081. In certain applications, it is indicated that the seal 1071 of a frit material in combination with the top and bottom plates 1061, 1002 provide a barrier to oxygen of less than approximately 10⁻³ cc/m²-day and to water of less than 10⁻⁶ g/m²-day. Given that some oxygen and moisture can permeate into the enclosed space 1081, a material that can take up oxygen and/or moisture is formed within the enclosed space 1081.

The seal 1071 has a width W, which is its thickness in a direction parallel to a surface of the top or bottom substrate 1061, 1002 as shown in Fig. 7D. The width varies among devices and ranges from about 300 *µ*m to about 3000 *µ*m, optionally from about 500 *µ*m to about 1500 *µ*m. Also, the width may vary at different positions of the seal 1071. In some cases, the width of the seal 1071 is the largest where it contacts one of the bottom and top substrate 1002, 1061 or a layer formed thereon. The width may be the smallest where the seal 1071 contacts the other. The width variation in a single cross-section of the seal 1071 relates to the cross-sectional shape of the seal 1071 and other design parameters.

The seal 1071 has a height H, which is its thickness in a direction perpendicular to a surface of the top or bottom substrate 1061, 1002 as shown in Fig. 7D. The height varies among embodiments and ranges from about 2 *µ*m to about 30 *µ*m, optionally from about 10 *µ*m to about 15 *µ*m. Generally, the height does not significantly vary at different positions of the seal 1071. However, in certain structures, the height of the seal 1071 may vary at different positions thereof.

In the illustrated device, the seal 1071 has a generally rectangular cross-section. In other structures, however, the seal 1071 can have other various cross-sectional shapes such as a generally square cross-section, a generally trapezoidal cross-section, a cross-section with one or more rounded edges, or other configuration as indicated by the needs of a given application. To improve hermeticity, it is generally desired to increase the interfacial area where the seal 1071 directly contacts the bottom or top substrate 1002, 1061 or a layer formed thereon. In some cases, the shape of the seal can be designed such that the interfacial area can be increased.

The seal 1071 can be arranged immediately adjacent the OLED array 1021, and in other cases, the seal 1071 is spaced some distance from the OLED array 1021. In certain cases, the seal 1071 comprises generally linear segments that are connected together to surround the OLED array 1021. Such linear segments of the seal 1071 can extend, in certain arrangements, generally parallel to respective boundaries of the OLED array 1021. In other arrangements, one or more of the linear segments of the seal 1071 are arranged in a non-parallel relationship with respective boundaries of the OLED array 1021. In yet other structures, at least part of the seal 1071 extends between the top plate 1061 and bottom plate 1002 in a curvilinear manner.

As noted above, in certain cases, the seal 1071 is formed using a frit material or simply "frit" or glass frit," which includes fine glass particles. The frit particles includes one or more of magnesium oxide (MgO), calcium oxide (CaO), barium oxide (BaO), lithium oxide (Li₂O), sodium oxide (Na₂O), potassium oxide (K₂O), boron oxide (B₂O₃), vanadium oxide (V₂O₅), zinc oxide (ZnO), tellurium oxide (TeO₂), aluminum oxide (Al₂O₃), silicon dioxide (SiO₂), lead oxide (PbO), tin oxide (SnO), phosphorous oxide (P₂O₅), ruthenium oxide (Ru₂O), rubidium oxide (Rb₂O), rhodium oxide (Rh₂O), ferrite oxide (Fe₂O₃), copper oxide (CuO), titanium oxide (TiO₂), tungsten oxide (WO₃), bismuth oxide (Bi₂O₃), antimony oxide (Sb₂O₃), lead-borate glass, tin-phosphate glass, vanadate glass, and borosilicate, etc. These particles range in size from about 2 *µ*m to about 30 *µ*m, optionally about 5 *µ*m to about 10 *µ*m, although not limited only thereto. The particles can be as large as about the distance between the top and bottom substrates 1061, 1002 or any layers formed on these substrates where the frit seal 1071 contacts.

The frit material used to form the seal 1071 can also include one or more filler or additive materials. The filler or additive materials can be provided to adjust an overall thermal expansion characteristic of the seal 1071 and/or to adjust the absorption characteristics of the seal 1071 for selected frequencies of incident radiant energy. The filler or additive material(s) can also include inversion and/or additive fillers to adjust a coefficient of thermal expansion of the frit. For example, the filler or additive materials can include transition metals, such as chromium (Cr), iron (Fe), manganese (Mn), cobalt (Co), copper (Cu), and/or vanadium. Additional materials for the filler or additives include ZnSiO₄, PbTiO₃, ZrO₂, eucryptite.

A frit material as a dry composition typically contains glass particles from about 20 to 90 about wt%, and the remainder includes fillers and/or additives. In some cases, the frit paste contains about 10-30 wt% organic materials and about 70-90% inorganic materials. In some cases, the frit paste contains about 20 wt% organic materials and about 80 wt% inorganic materials. In some cases, the organic materials may include about 0-30 wt% binder(s) and about 70-100 wt% solvent(s). In some cases, about 10 wt% is binder(s) and about 90 wt% is solvent(s) among the organic materials. In some cases, the inorganic materials may include about 0-10 wt% additives, about 20-40 wt% fillers and about 50-80 wt% glass powder. In some cases, about 0-5 wt% is additive(s), about 25-30 wt% is filler(s) and about 65-75 wt% is the glass powder among the inorganic materials.

In forming a frit seal, a liquid material is added to the dry frit material to form a frit paste. Any organic or inorganic solvent with or without additives can be used as the liquid material. Typically, the solvent includes one or more organic compounds. For example, applicable organic compounds are ethyl cellulose, nitro cellulose, hydroxyl propyl cellulose, butyl carbitol acetate, terpineol, butyl cellusolve, acrylate compounds. Then, the thus formed frit paste can be applied to form a shape of the seal 1071 on the top and/or bottom plate 1061, 1002.

In one arrangement, a shape of the seal 1071 is initially formed from the frit paste and interposed between the top plate 1061 and the bottom plate 1002. The seal 1071 can in certain arrangements be pre-cured or pre-sintered to one of the top plate and bottom plate 1061, 1002. Following assembly of the top plate 1061 and the bottom plate 1002 with the seal 1071 interposed therebetween, portions of the seal 1071 are selectively heated such that the frit material forming the seal 1071 at least partially melts. The seal 1071 is then allowed to resolidify to form a secure joint between the top plate 1061 and the bottom plate 1002 to thereby inhibit exposure of the enclosed OLED pixel array 1021 to oxygen or water.

The selective heating of the frit seal is carried out by irradiation of light, such as a laser or directed infrared lamp. As previously noted, the frit material forming the seal 1071 can be combined with one or more additives or filler such as species selected for improved absorption of the irradiated light to facilitate heating and melting of the frit material to form the seal 1071.

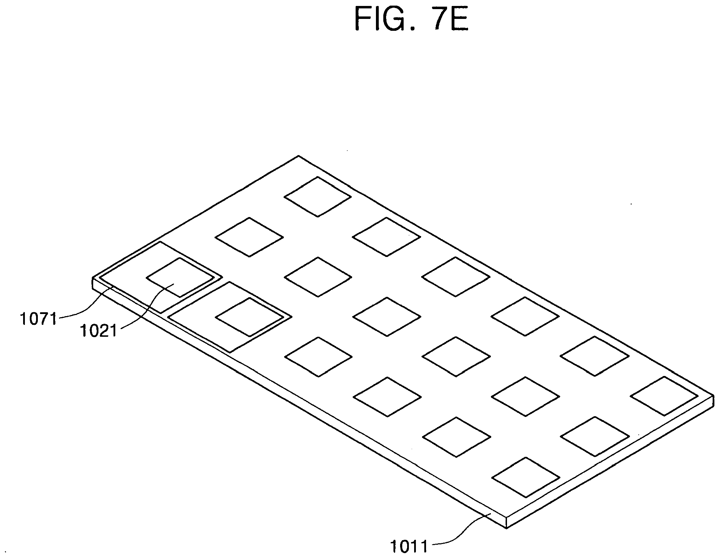

OLED devices 1011 are often mass produced. In an embodiment illustrated in Fig. 7E, a plurality of separate OLED arrays 1021 is formed on a common bottom substrate 1101. In the illustrated arrangement, each OLED array 1021 is surrounded by a shaped frit to form the seal 1071. Common top substrate (not shown) is placed over the common bottom substrate 1101 and the structures formed thereon such that the OLED arrays 1021 and the shaped frit paste are interposed between the common bottom substrate 1101 and the common top substrate. The OLED arrays 1021 are encapsulated and sealed, such as via the previously described enclosure process for a single OLED display device. The resulting product includes a plurality of OLED devices kept together by the common bottom and top substrates. Then, the resulting product is cut into a plurality of pieces, each of which constitutes an OLED device 1011 of Fig. 7D. The individual OLED devices 1011 then further undergo additional packaging operations to further improve the sealing formed by the frit seal 1071 and the top and bottom substrates 1061, 1002.

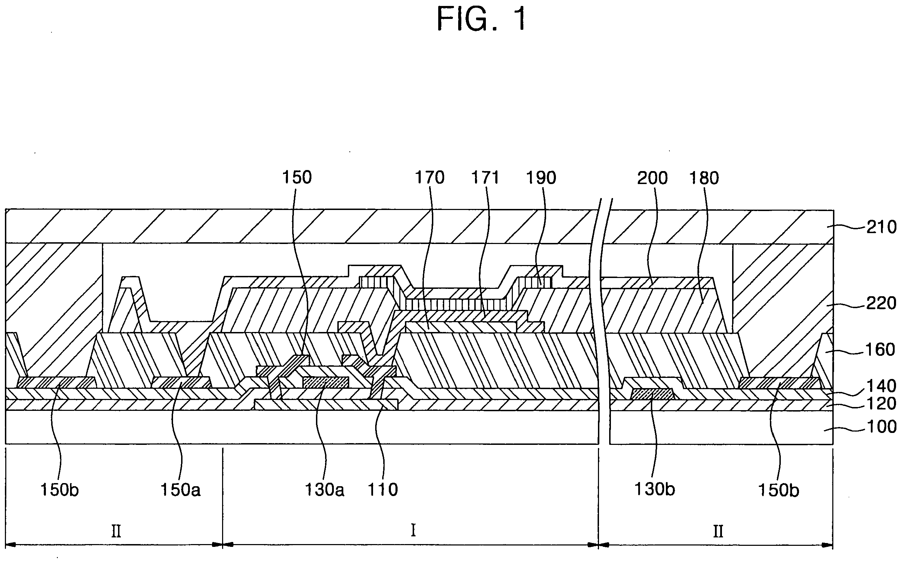

FIG. 1 is a cross-sectional view of an organic light emitting display not according to the invention. Referring to FIG. 1, the organic light emitting display includes a semiconductor layer 110, a gate insulating layer 120, a gate electrode 130a, a scan driver 130b, an interlayer insulating layer 140, and source and drain electrodes 150, which are disposed on a substrate 100 having a pixel region I and a non-pixel region II. In addition, the organic light emitting display further includes a common power supply line 150b, and a second electrode power supply line 150a, which are formed of source and drain interconnections.

A planarization layer 160 is disposed on the entire surface of the substrate 100. The planarization layer 160 is formed of an organic material such as acryl-based resin or polyimide-based resin. The planarization layer 160 has via-holes for exposing the common power supply line 150b, the second electrode power supply line 150a, and the source and/or drain electrodes 150. The common power supply line 150b is partially exposed to enhance adhesive strength when the substrate is sealed using a glass frit.

A first electrode 171 including a reflective layer 170 is disposed on the substrate 100, and a pixel defining layer 180 is disposed on the entire surface of the substrate 100. An organic layer 190 including at least an emission layer is disposed on the first electrode 171, and a second electrode 200 is disposed thereon. An encapsulation substrate 210 is disposed opposite to the substrate 100, and the substrate 100 and the encapsulation substrate 210 are sealed with a glass frit 220, thereby forming an organic light emitting display.

However, in the foregoing example, the organic light emitting display includes an organic planarization layer disposed under the glass frit for sealing the substrate so that the organic planarization layer may be damaged due to a large amount of heat generated when a laser beam is radiated to the glass frit. As a result, adhesive strength at an interface in which the glass frit is adhered to the organic planarization layer may be lowered.

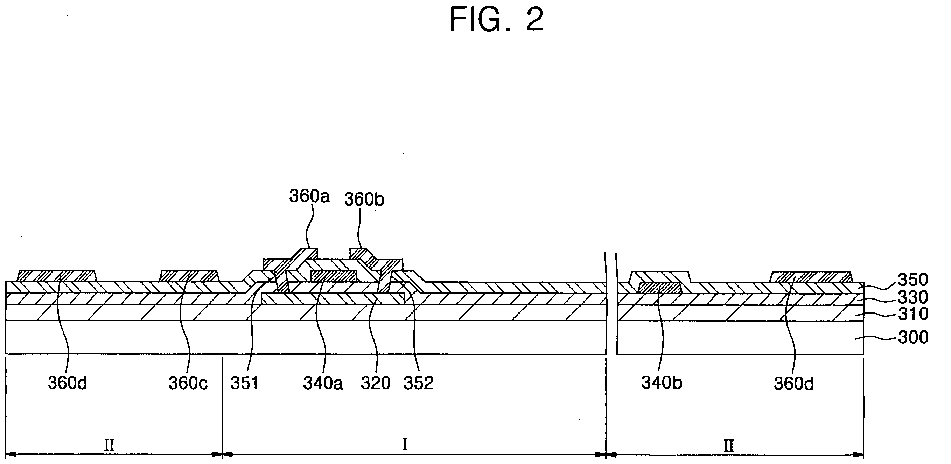

FIGS. 2 to 5 are cross-sectional views of an organic light emitting display not according to the invention. Referring to FIG. 2, a substrate 300 including a pixel region I, and a non-pixel region II is provided. The substrate 300 may be an insulating glass substrate, a plastic substrate, or a conductive substrate.

A buffer layer 310 is formed on the surface of the substrate 300. The buffer layer 310 may be a silicon oxide layer, a silicon nitride layer, or a composite layer of silicon oxide and silicon nitride. In one aspect, the buffer layer 310 functions as a passivation layer for preventing impurities from out-diffusing from the substrate 300.

A semiconductor layer 320 is formed on the buffer layer 310 in the pixel region I. The semiconductor layer 320 may be an amorphous silicon layer or a polysilicon layer. A gate insulating layer 330 is formed on the surface of the substrate 300 and the semiconductor layer 320. The gate insulating layer 330 may be a silicon oxide layer, a silicon nitride layer, or a composite layer of silicon oxide and silicon nitride.

After forming the gate insulating layer 330, a gate electrode 340a is formed on the gate insulating layer 330 located above a portion of the semiconductor layer 320. The gate electrode 340a may be comprised of Al, Cu, and/or Cr.

An interlayer insulating layer 350 is formed on the surface of the substrate 300 and the gate electrode 340a. The interlayer insulating layer 350 may be a silicon oxide layer, a silicon nitride layer, or a composite layer of silicon oxide and silicon nitride.

The interlayer insulating layer 350 and the gate insulating layer 330 in the pixel region I are then etched to form contact holes 351 and 352 for exposing the semiconductor layer 320. Source and drain electrodes 360a and 360b are formed on the interlayer insulating layer 350 in the pixel region I connecting to the semiconductor layer 320 through the contact holes 351 and 352. The source and drain electrodes 360a and 360b may be formed of one or more materials including, for example, Mo, Cr, Al, Ti, Au, Pd and Ag.

Further, at the same time the source and drain electrodes 360a and 360b are formed, the electrically conductive line 360d is formed in the non-pixel region II. The electrically conductive line 360d may act as a common power supply line. In addition, a second electrode power supply line 360c may also be formed at the same time. Furthermore, at the same time the gate electrode 340a is formed, a scan driver line 340b may be formed in the non-pixel region II.

While a top gate thin film transistor configuration is described in this embodiment, a bottom gate thin film transistor having a gate electrode disposed under a semiconductor layer may also be formed. In addition, while the electrically conductive line, in this embodiment, is formed at the same time the source and drain electrodes are formed, the electrically conductive line may also be formed at the same time the gate electrode or the first electrode is formed.

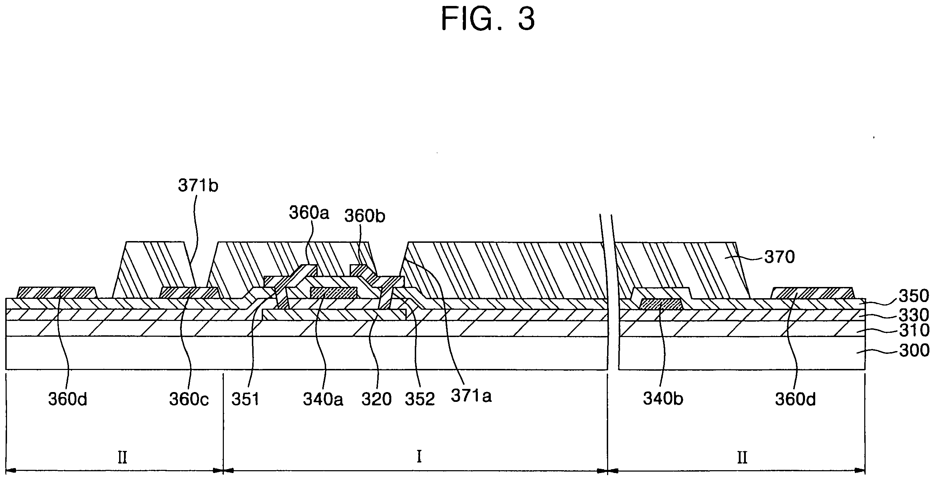

Referring to FIG. 3, an organic planarization layer 370 is formed on the surface of the substrate 300. The organic planarization layer 370 may be formed using an organic material such as acryl-based resin, polyimide-based resin, or benzocyclobutene (BCB). The organic planarization layer 370 is then etched to form via-holes 371a and 371b for exposing at least one of the source and/or drain electrodes 360a and 360b in the pixel region I, and the second electrode power supply line 360c in the non-pixel region II.

In addition, the organic planarization layer 370 in the non-pixel region II, where the electrically conductive line 360d is located, is removed by etching to form a recess exposing the electrically conductive line 360d. When the substrate is sealed using a glass frit, the glass frit is irradiated with a laser beam to adhere the substrates. At this time, if the organic planarization layer still existed under the glass frit, the planarization layer may be damaged due to a large amount of heat generated from the laser. As a result, the glass frit may be delaminated from an interface with the planarization layer to decrease adhesive strength thereof. Therefore, the organic planarization layer at the edge of the substrate 300, to which the glass frit is to be adhered, is removed to prevent the above problems.

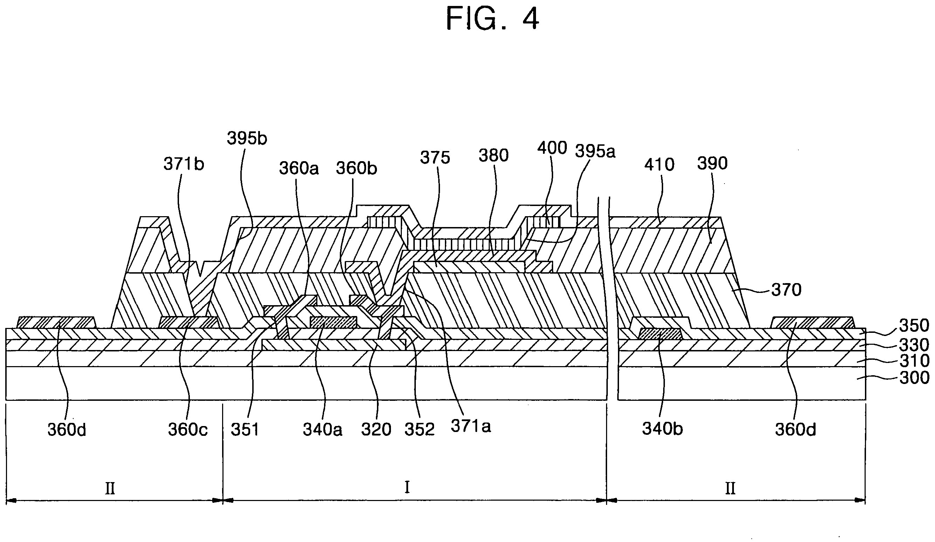

Referring to FIG. 4, a first electrode 380 including a reflective layer 375 is formed on the organic planarization layer 370 in the pixel region I. The first electrode 380 is disposed on a bottom surface of the via-hole 371 to be in contact with one of the exposed source and/or drain electrodes 360a and 360b, and extends onto the organic planarization layer 370. The first electrode 380 may be formed of indium tin oxide (ITO) or indium zinc oxide (IZO).

After forming the first electrode 380, a pixel defining layer 390 is formed on the surface of the substrate 300 including at least the first electrode 380. The pixel defining layer is formed to a thickness sufficient to fill the via-hole 371a, in which the first electrode 380 is disposed. The pixel defining layer 390 may be formed of an organic layer or an inorganic layer, preferably, an organic layer. More preferably, the pixel defining layer 390 is formed of one selected from the group including BCB, acryl-based polymer, and polyimide. The material comprising the pixel defining layer 390 preferably has high flowability such that the pixel defining layer can be evenly formed on the entire surface of the substrate.

At this time, the pixel defining layer 390 is etched to form openings 395a for exposing the first electrode 380 in the pixel region I, and a portion of the second electrode power supply line 360c in the non-pixel region II. In addition, the pixel defining layer 390 in the non-pixel region II, at which the electrically conductive line 360d is disposed, is also removed by etching.

After forming the pixel defining layer 390 and etching the opening 395a, an organic layer 400 is formed on the first electrode 380 exposed through the opening 395a. The organic layer 400 includes at least an emission layer, and may further include at least one of a hole injection layer, a hole transport layer, an electron transport layer, and an electron injection layer.

Next, a second electrode 410 is formed on the surface of the substrate 300. The second electrode 410 is a transmissive electrode, and may be formed of Mg, Ag, Al, Ca, or an alloy thereof, which is transparent and has a low work function. At this time, the second electrode 410 is etched to expose the electrically conductive line 360d in the non-pixel region II.

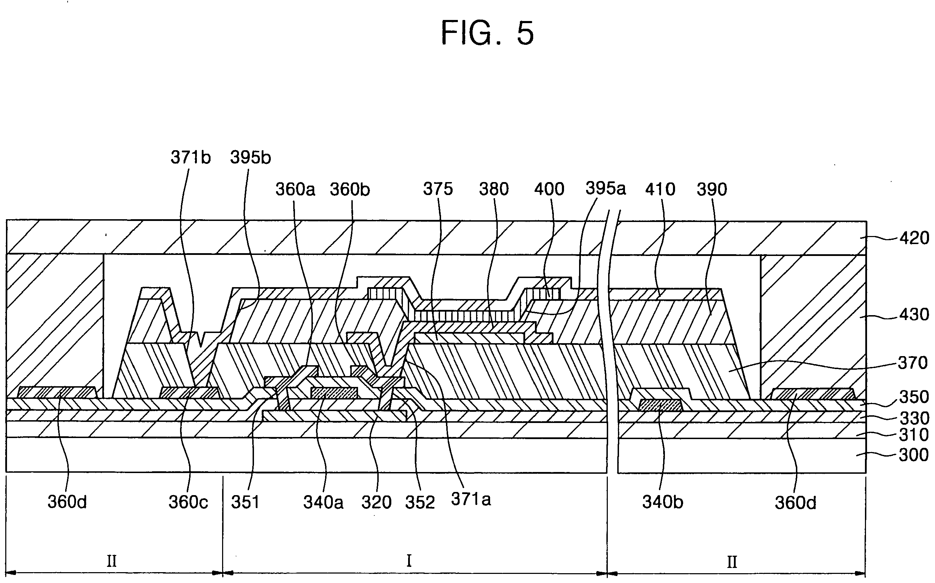

Referring to FIG. 5, an encapsulation substrate 420 opposite to the substrate 300 is provided. The encapsulation substrate 420 may be formed of an etched insulating glass or a non-etched insulating glass.

In this example, a glass frit 430 is applied to the edge of the encapsulation substrate 420 opposite to the substrate 300. The glass frit 430 may be formed of material selected from the group consisting ofmagnesium oxide (MgO), calcium oxide (CaO), barium oxide (BaO), lithium oxide (Li₂O), sodium oxide (Na₂O), potassium oxide (K₂O), boron oxide (B₂O₃), vanadium oxide (V₂O₅), zinc oxide (ZnO), tellurium oxide (TeO₂), aluminum oxide (Al₂O₃), silicon dioxide (SiO₂), lead oxide (PbO), tin oxide (SnO), phosphorous oxide (P₂O₅), ruthenium oxide (Ru₂O), rubidium oxide (Rb₂O), rhodium oxide (Rh₂O), ferrite oxide (Fe₂O₃), copper oxide (CuO), titanium oxide (TiO₂), tungsten oxide (WO₃), bismuth oxide (Bi₂O₃), antimony oxide (Sb₂O₃), lead-borate glass, tin-phosphate glass, vanadate glass, and borosilicate, and a composite thereof. The glass frit 430 may be applied by a dispensing method or a screen printing method.

In the example shown in Figure 5, the glass frit 430 has a width larger than that of the electrically conductive line 360d. As the glass frit 430 has a larger width, the adhesive strength increases. Therefore, it is possible to protect an element from external moisture or oxygen. In this example, the glass frit 430 is applied on the encapsulating substrate 420. In other examples, the glass frit 430 may be applied on the substrate 300, or on both the substrate 300 and the encapsulation substrate 420.

After applying the glass frit 430, the substrate 300 and the encapsulation substrate 420 are aligned and adhered to each other. At this time, the glass frit 430 is in contact with the electrically conductive line 360d and the interlayer insulating layer 350 on the substrate 300.

After contacting the substrate 300 with the encapsulation substrate 420 via the glass frit 430, the glass frit 430 is irradiated with a laser beam. The glass frit 430 is melted and solidified to adhere the substrate 300 and the encapsulation substrate 420, thereby completing the organic light emitting display of an embodiment.

It should be noted, that while the example described above in reference to FIGS. 2-5 showed a single organic light emitting pixel being encapsulated, similar procedures may be used to encapsulate an array of organic light emitting pixels. Additionally, multiple arrays of organic light emitting pixels may be encapsulated between a single substrate 300 and a single encapsulation substrate 420 and be surrounded by additional glass frits 430 (e.g., in a mass production configuration). The multiple arrays may be cut apart resulting in individual arrays encapsulated by the substrate 300, the encapsulation substrate 420 and a glass frit 430.

As described above, if the organic planarization layer is disposed under the glass frit for sealing the substrate, the organic planarization layer may be damaged due to the large amount of heat generated when the laser beam is radiated to the glass frit. As a result, the glass frit may be delaminated from an interface with the planarization layer to decrease adhesive strength thereof. On the other hand, the organic planarization layer in the area of the glass frit may be removed to prevent adhesive strength of the glass frit from being lowered.

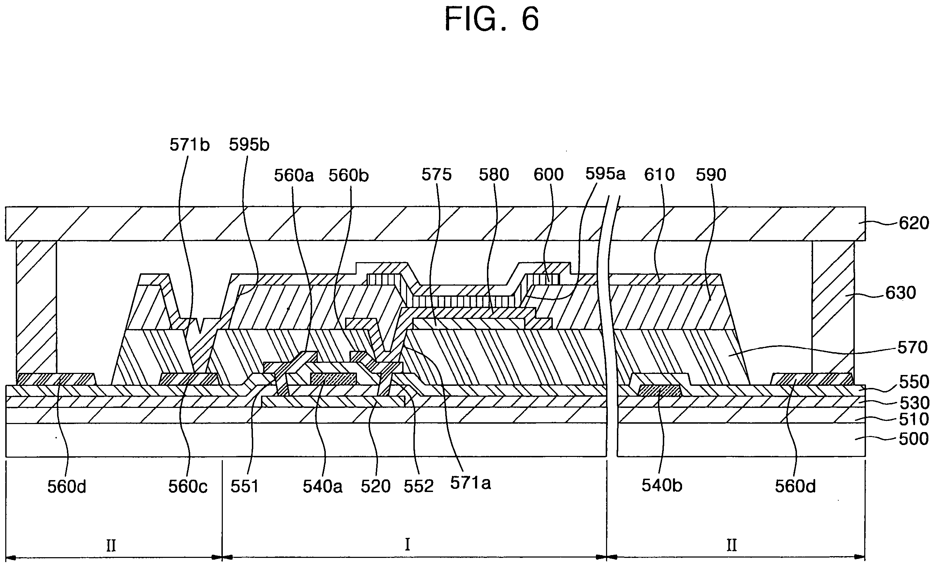

FIG. 6 is a cross-sectional view of an organic light emitting display in accordance with the embodiment of the present invention. Referring to FIG. 6, the organic light emitting display is formed in a manner similar to the example discussed above in reference to FIGS. 2-5, where a glass frit 630 is applied on an encapsulating substrate 620, and a substrate 500 is adhered to the encapsulating substrate 620. The glass frit 630 is then irradiated with a laser beam such that the glass frit 630 is melted and solidified, thereby completing the organic light emitting display.

In this embodiment, the glass frit 630 has a width smaller than that of the electrically conductive line 560d. In the example shown in FIG. 5, the glass frit 430 was wider than the electrically conductive line 360d, and the electrically conductive line 360d substantially eclipses the glass frit 430 as viewed from the substrate 300. While the wider glass frit 430 may provide increased adhesive strength compared to the glass frit 630, a narrower glass frit such as the glass frit 630 may be sufficient, depending on the embodiment. In addition, since an organic planarization layer does not exist under the glass frit (either the glass frit 430 or the glass frit 630), it is possible to prevent the adhesive strength of either of the glass frits 430 or 630 from being lowered.

In this embodiment, the glass frit 630 is applied on the encapsulating substrate 620. In other embodiments, the glass frit 430 may be applied on the substrate 500, or on both the substrate 500 and the encapsulating substrate 620.

As described above, in embodiments not according to the invention, where the organic planarization layer is disposed under the glass frit for sealing the substrate, the organic planarization layer may be damaged due to the large amount of heat generated when the laser beam is radiated to the glass frit. As a result, the glass frit may be delaminated from an interface with the planarization layer to decrease adhesive strength thereof. However, in the embodiment, the organic planarization layer under the glass frit is removed to prevent adhesive strength of the glass frit from being lowered. Therefore, it is possible to prevent intrusion of external moisture or oxygen to improve reliability of an element.

While the foregoing embodiment of the present invention exemplarily describe the electrically conductive line positioned at both sides of the substrate and disposed under the glass frit, the electrically conductive line may be disposed at one side of the substrate and under the glass frit.

As can be seen from the foregoing, an organic light emitting display and a method of fabricating the same in accordance with the embodiment of the present invention can prevent adhesive strength of a glass frit from being lowered when a substrate is sealed using the glass frit, thereby improving reliability.

Although the present invention has been described with reference to certain embodiments thereof, it will be understood by those skilled in the art that a variety of modifications and variations may be made to the present invention without departing from the scope of the present invention defined in the appended claims.

## Claims

1. An organic light emitting device comprising:
a first substrate (500) comprising a pixel region and a non-pixel region;
an array of organic light emitting pixels formed over the pixel region of the first substrate;
a second substrate (620) placed over the first substrate (500), the array being interposed between the first and second substrates;
an electrically conductive line (560d) formed over the non-pixel region of the first substrate (500) and not overlapping the array; and
a planarization layer (570) formed over the first substrate (500);
**characterized by** a frit seal (630) interposed between the first and second substrates and surrounding the array such that the array is encapsulated by the first substrate (500), the second substrate (620) and the frit seal (630), wherein the electrically conductive line (560d) comprises a portion overlapping the frit seal (630) in a segment of the device such that the portion of the electrically conductive line wholly eclipses the frit seal (630) in the segment when viewed from the first substrate (500);
wherein the frit seal (630) does not contact the planarization layer (570);
wherein the frit seal (630) has a width taken in a cross-sectional plane, and the electrically conductive line (560d) has a width taken in the cross-sectional plane, and wherein the width of the frit seal (630) is smaller than the width of the electrically conductive line (560d), and
wherein the frit seal (630) connects to the electrically conductive line (560d) without a material therebetween.

2. A device according to Claim 1, wherein the device further comprises at least one layer located between the electrically conductive line (560d) and the first substrate (500), the at least one layer comprising an organic material.

3. A device according to any one of Claims 1 or 2, wherein the electrically conductive line (560d) further comprises a portion that does not overlap the frit seal (630).

4. A device according to any one of Claims 1 to 3, wherein the electrically conductive line (560d) extends along a peripheral edge of the first substrate (500), and wherein the frit seal (630) extends along the peripheral edge of the first substrate (500).

5. A device according to any one of Claims 1 to 4, wherein the electrically conductive line (560d) is made of metal.

6. A device according to any one of Claims 1 to 5, wherein in another segment of the device, the frit seal (630) further comprises a non-eclipsed portion that is not eclipsed by the electrically conductive line (560d) when viewed from the first substrate (500).

7. A device according to any preceding Claim, wherein the electrically conductive line (560d) comprises a power supply line electrically connected to the array.

8. A device according to any one of Claims 1 to 7, wherein the electrically conductive line (560d) comprises a portion overlapping the frit seal (630) throughout the device such that the portion of the electrically conductive line (560d) eclipses the frit seal (630) when viewed from the first substrate (500).

9. A device according to any one of Claims 1 to 8, wherein the planarization layer is formed over at least part of the non-pixel region of the first substrate (500).

10. A device according to any one of Claims 1 to 9, wherein the planarization layer is an organic planarization layer formed over at least part of the non-pixel region of the first substrate (500), wherein the planarization layer comprises a recess exposing the electrically conductive line (560d).

11. A device according to any one of Claims 1 to 10, further comprising a plurality of thin film transistors interposed between the first substrate (500) and the array, wherein the electrically conductive line (560d) is made of a material used in the plurality of thin film transistors.

12. A device according to any one of Claims 1 to 11, wherein the frit seal (630) comprises one or more materials selected from the group consisting of magnesium oxide (MgO), calcium oxide (CaO), barium oxide (BaO), lithium oxide (Li₂O), sodium oxide (Na₂O), potassium oxide (K₂O), boron oxide (B₂O₃), vanadium oxide (V₂O_{S}), zinc oxide (ZnO), tellurium oxide (TeO₂), aluminum oxide (Al₂O₃), silicon dioxide (SiO₂), lead oxide (PbO), tin oxide (SnO), phosphorous oxide (P₂O₅), ruthenium oxide (Ru₂O), rubidium oxide (Rb₂O), rhodium oxide (Rh₂O), ferrite oxide (Fe₂O₃), copper oxide (CuO), titanium oxide (TiO₂), tungsten oxide (WO₃), bismuth oxide (Bi₂O₃), antimony oxide (Sb₂O₃), lead-borate glass, tin-phosphate glass, vanadate glass, and borosilicate.

13. A device according to any one of claims Claim 1 to 12, wherein the planarization layer comprises a recess, and wherein at least part of the frit seal (630) extends into the recess.

14. A device according to any one of claims Claim 1 to 13, wherein the planarization layer extends over at least part of the pixel region and at least part of the non-pixel region.

15. A device according to any one of Claims 1 to 14, wherein the planarization layer comprises an organic material.

16. A method of making an organic light emitting device, the method comprising:
providing an unfinished device comprising a first substrate (500), an array of organic light emitting pixels formed over the first substrate (500), an electrically conductive line (560d) formed over the first substrate (500) and not overlapping the array, and a planarization layer formed over the first substrate (500);
further providing a second substrate (620);
interposing a frit (630) between the first and second substrates such that the array is interposed between the first and second substrates, that the frit (630) surrounds the array, does not contact the planarization layer and contacts the electrically conductive line (560d) and that a portion of the electrically conductive line (560d) overlaps the frit in a segment of the device, wherein the frit seal (630) has a width taken in a cross-sectional plane, and the electrically conductive line (560d) has a width taken in the cross-sectional plane, and wherein the width of the frit seal (630) is smaller than the width of the electrically conductive line (560d), whereby the portion of the electrically conductive line (560d) wholly eclipses the frit (630) in the segment when viewed from the first substrate; and
melting and resolidifying at least part of the frit (630) so as to interconnect the unfinished device and the second substrate via the frit, wherein the frit connects to the electrically conductive line (560d) without a material therebetween, and wherein the frit (630) connects to the second substrate (620) with or without a material therebetween.

17. A method according to Claim 16, wherein interposing comprises contacting the frit (630) with the portion of the electrically conductive line (560d) and the second substrate (620).

18. A method according to Claim 16 or 17, wherein the unfinished device further comprises the planarization layer being formed over the first substrate (500) with an opening exposing part of the electrically conductive line (560d), and wherein interposing the frit (630) comprises contacting the frit (630) with the electrically conductive line (560d) through the opening.

19. A method according to Claim 18, wherein providing the unfinished device comprises:
providing the planarization layer over the electrically conductive line (560d); and
selectively etching the planarization layer to form the opening prior to interposing the frit (630).

20. A method according to any one of Claims 16 to 19, wherein the melting comprises irradiating a laser beam or infrared ray to at least part of the frit (630).

21. A method according to any one of Claims 16 to 20, wherein interposing the frit comprises:
forming the frit (630) over at least one of the first and second substrates; and
arranging the first and second substrate so as to interpose the frit (630) therebetween.

22. A method according to Claim 21, wherein forming the frit comprises screen-printing or dispensing a material of the frit (630) over at least one of the first and second substrates.

23. A method according to any one of Claims 16 to 22, wherein the unfinished device further comprises one or more additional arrays of organic light emitting pixels and one or more additional electrically conductive lines formed over the first substrate;
wherein the method further comprises forming one or more additional frits between the first and second substrates such that each additional frit surrounds one of the additional arrays and contacts a portion of one of the additional electrically conductive lines.

24. A method according to Claim 23, wherein the one of the additional electrically conductive lines wholly eclipses the additional frit.

25. A method according to Claim 23 or 24, further comprising cutting the resulting product of Claim 23 into two or more pieces, wherein one of the pieces comprises the frit and the array interposed between the first and second substrate.

## Patentansprüche

1. Organische lichtemittierende Vorrichtung, umfassend:
ein erstes Substrat (500), das eine Pixelregion und eine Nichtpixelregion umfasst;
eine Anordnung von organischen lichtemittierenden Pixeln, die über der Pixelregion des ersten Substrats gebildet ist;
ein zweites Substrat (620), das über dem ersten Substrat (500) angeordnet ist, wobei die Anordnung zwischen dem ersten und zweiten Substrat angeordnet ist;
eine elektrisch leitfähige Leitung (560d), die über der Nichtpixelregion des ersten Substrats (500) gebildet ist und die Anordnung nicht überlappt; und
eine Planarisierungsschicht (570), die über dem ersten Substrat (500) gebildet ist;
**gekennzeichnet durch** eine Frittedichtung (630), die zwischen dem ersten und zweiten Substrat angeordnet ist und die Anordnung derart umgibt, dass die Anordnung von dem ersten Substrat (500), dem zweiten Substrat (620) und der Frittedichtung (630) eingekapselt ist, wobei die elektrisch leitfähige Leitung (560d) einen Abschnitt umfasst, der die Frittedichtung (630) in einem Segment der Vorrichtung derart überlappt, dass der Abschnitt der elektrisch leitfähigen Leitung die Frittedichtung (630) in dem Segment von dem ersten Substrat (500) aus betrachtet vollständig verdeckt;
wobei die Frittedichtung (630) die Planarisierungsschicht (570) nicht kontaktiert;
wobei die Frittedichtung (630) in einer Querschnittsebene eine Breite aufweist und die elektrisch leitfähige Leitung (560d) in der Querschnittsebene eine Breite aufweist, und wobei die Breite der Frittedichtung (630) kleiner ist als die Breite der elektrisch leitfähigen Leitung (560d), und
wobei die Frittedichtung (630) ohne ein Material dazwischen mit der elektrisch leitfähigen Leitung (560d) verbunden ist.

2. Vorrichtung nach Anspruch 1, wobei die Vorrichtung ferner mindestens eine Schicht umfasst, die zwischen der elektrisch leitfähigen Schicht (560d) und dem ersten Substrat (500) angeordnet ist, wobei die mindestens eine Schicht ein organisches Material umfasst.

3. Vorrichtung nach einem der Ansprüche 1 oder 2, wobei die elektrisch leitfähige Leitung (560d) ferner einen Abschnitt umfasst, der die Frittedichtung (630) nicht überlappt.

4. Vorrichtung nach einem der Ansprüche 1 bis 3, wobei die elektrisch leitfähige Leitung (560d) sich entlang eines Umfangsrands des ersten Substrats (500) erstreckt und wobei die Frittedichtung (630) sich entlang des Umfangsrands des ersten Substrats (500) erstreckt.

5. Vorrichtung nach einem der Ansprüche 1 bis 4, wobei die elektrisch leitfähige Leitung (560d) aus Metall hergestellt ist.

6. Vorrichtung nach einem der Ansprüche 1 bis 5, wobei in einem anderen Segment der Vorrichtung die Frittedichtung (630) ferner einen nicht verdeckten Abschnitt umfasst, der von dem ersten Substrat (500) aus betrachtet nicht von der elektrisch leitfähigen Leitung (560d) verdeckt wird.

7. Vorrichtung nach einem vorangehenden Anspruch, wobei die elektrisch leitfähige Leitung (560d) eine Stromversorgungsleitung umfasst, die elektrisch mit der Anordnung verbunden ist.

8. Vorrichtung nach einem der Ansprüche 1 bis 7, wobei die elektrisch leitfähige Leitung (560d) einen Abschnitt umfasst, der die Frittedichtung (630) in der gesamten Vorrichtung überlappt, sodass der Abschnitt der elektrisch leitfähigen Leitung (560d) die Frittedichtung (630) von dem ersten Substrat (500) aus betrachtet verdeckt.

9. Vorrichtung nach einem der Ansprüche 1 bis 8, wobei die Planarisierungsschicht über mindestens einem Teil der Nichtpixelregion des ersten Substrats (500) gebildet ist.

10. Vorrichtung nach einem der Ansprüche 1 bis 9, wobei die Planarisierungsschicht eine organische Planarisierungsschicht ist, die über mindestens einem Teil der Nichtpixelregion des ersten Substrats (500) gebildet ist, wobei die Planarisierungsschicht eine Aussparung umfasst, die die elektrisch leitfähige Leitung (560d) freilegt.

11. Vorrichtung nach einem der Ansprüche 1 bis 10, ferner umfassend eine Mehrzahl von Dünnfilmtransistoren, die zwischen dem ersten Substrat (500) und der Anordnung angeordnet sind, wobei die elektrisch leitfähige Leitung (560d) aus einem Material hergestellt ist, das in der Mehrzahl von Dünnfilmtransistoren verwendet wird.

12. Vorrichtung nach einem der Ansprüche 1 bis 11, wobei die Frittedichtung (630) ein oder mehrere Materialien umfasst, die ausgewählt sind aus der Gruppe bestehend aus Magnesiumoxid (MgO), Calciumoxid (CaO), Bariumoxid (BaO), Lithiumoxid (Li₂O), Natriumoxid (Na₂O), Kaliumoxid (K₂O), Boroxid (B₂O₃), Vanadiumoxid (V₂O₅), Zinkoxid (ZnO), Telluroxid (TeO₂), Aluminiumoxid (Al₂O₃), Siliziumdioxid (SiO₂), Bleioxid (PbO), Zinnoxid (SnO), Phosphoroxid (P₂O₅), Rutheniumoxid (Ru₂O), Rubidiumoxid (Rb₂O), Rhodiumoxid (Rh₂O), Ferritoxid (Fe₂O₃), Kupferoxid (CuO), Titanoxid (TiO₂), Wolframoxid (WO₃), Bismutoxid (Bi₂O₃), Antimonoxid (Sb₂O₃), Bleiboratglas, Zinnphosphatglas, Vanadatglas und Borosilikat.

13. Vorrichtung nach einem der Ansprüche 1 bis 12, wobei die Planarisierungsschicht eine Aussparung umfasst und wobei mindestens ein Teil der Frittedichtung (630) sich in die Aussparung erstreckt.

14. Vorrichtung nach einem der Ansprüche 1 bis 13, wobei die Planarisierungsschicht sich über mindestens einen Teil der Pixelregion und mindestens einen Teil der Nichtpixelregion erstreckt.

15. Vorrichtung nach einem der Ansprüche 1 bis 14, wobei die Planarisierungsschicht ein organisches Material umfasst.

16. Verfahren zur Herstellung einer organischen lichtemittierenden Vorrichtung, wobei das Verfahren Folgendes umfasst:
Bereitstellen einer unfertigen Vorrichtung, die ein erstes Substrat (500), eine Anordnung von organischen lichtemittierenden Pixeln, die über dem ersten Substrat (500) gebildet ist, eine elektrisch leitfähige Leitung (560d), die über dem ersten Substrat (500) gebildet ist und die Anordnung nicht überlappt, und eine Planarisierungsschicht umfasst, die über dem ersten Substrat (500) gebildet ist;
ferner Bereitstellen eines zweiten Substrats (620);
Anordnen einer Fritte (630) zwischen dem ersten und zweiten Substrat, derart, dass die Anordnung zwischen dem ersten und zweiten Substrat angeordnet ist, derart, dass die Fritte (630) die Anordnung umgibt, die Planarisierungsschicht nicht kontaktiert und die elektrisch leitfähige Leitung (560d) kontaktiert, und derart, dass ein Abschnitt der elektrisch leitfähigen Leitung (560d) die Fritte in einem Segment der Vorrichtung überlappt, wobei die Frittedichtung (630) in einer Querschnittsebene eine Breite aufweist und die elektrisch leitfähige Leitung (560d) in der Querschnittsebene eine Breite aufweist, und wobei die Breite der Frittedichtung (630) kleiner ist als die Breite der elektrisch leitfähigen Leitung (560d), wodurch der Abschnitt der elektrisch leitfähigen Leitung (560d) die Fritte (630) in dem Segment von dem ersten Substrat aus betrachtet vollständig verdeckt; und
Schmelzen und wieder Erstarrenlassen mindestens eines Teils der Fritte (630), um die unfertige Vorrichtung und das zweite Substrat über die Fritte zu verbinden, wobei die Fritte ohne ein Material dazwischen mit der elektrisch leitfähigen Leitung (560d) verbunden ist, und wobei die Fritte (630) mit oder ohne ein Material dazwischen mit dem zweiten Substrat (620) verbunden ist.

17. Verfahren nach Anspruch 16, wobei das Zwischenanordnen das Kontaktieren der Fritte (630) mit dem Abschnitt der elektrisch leitfähigen Leitung (560d) und dem zweiten Substrat (620) umfasst.

18. Verfahren nach Anspruch 16 oder 17, wobei die unfertige Vorrichtung ferner das Bilden der Planarisierungsschicht über dem ersten Substrat (500) mit einem öffnungsfreilegenden Teil der elektrisch leitfähigen Leitung (560d) umfasst, und wobei das Zwischenanordnen der Fritte (630) das Kontaktieren der Fritte (630) mit der elektrisch leitfähigen Leitung (560d) durch die Öffnung umfasst.

19. Verfahren nach Anspruch 18, wobei das Bereitstellen der unfertigen Vorrichtung Folgendes umfasst:
Bereitstellen der Planarisierungsschicht über der elektrisch leitfähigen Leitung (560d); und
selektives Ätzen der Planarisierungsschicht, um vor Zwischenanordnung der Fritte (630) die Öffnung zu bilden.

20. Verfahren nach einem der Ansprüche 16 bis 19, wobei das Schmelzen das Bestrahlen mindestens eines Teils der Fritte (630) mit einem Laserstrahl oder Infrarotstrahl umfasst.

21. Verfahren nach einem der Ansprüche 16 bis 20, wobei das Zwischenanordnen der Fritte Folgendes umfasst:
Bilden der Fritte (630) über dem ersten und/oder zweiten Substrat; und
Anordnen des ersten und zweiten Substrats derart, dass die Fritte (630) dazwischen angeordnet ist.

22. Verfahren nach Anspruch 21, wobei das Bilden der Fritte Siebdruck oder das Verteilen eines Materials der Fritte (630) über dem ersten und/oder zweiten Substrat umfasst.

23. Verfahren nach einem der Ansprüche 16 bis 22, wobei die unfertige Vorrichtung ferner eine oder mehrere zusätzliche Anordnungen von organischen lichtemittierenden Pixeln und eine oder mehrere zusätzliche elektrisch leitfähige Leitungen umfasst, die über dem ersten Substrat gebildet sind;
wobei das Verfahren ferner das Bilden einer oder mehrerer zusätzlicher Fritten zwischen dem ersten und zweiten Substrat umfasst, derart, dass jede zusätzliche Fritte eine der zusätzlichen Anordnungen umgibt und einen Abschnitt einer der zusätzlichen elektrisch leitfähigen Leitungen kontaktiert.

24. Verfahren nach Anspruch 23, wobei die eine der zusätzlichen elektrisch leitfähigen Leitungen die zusätzliche Fritte vollständig verdeckt.

25. Verfahren nach Anspruch 23 oder 24, ferner umfassend das Schneiden des resultierenden Produkts von Anspruch 23 in zwei oder mehr Stücke, wobei eines der Stücke die Fritte und die Anordnung umfasst, die zwischen dem ersten und zweiten Substrat angeordnet sind.

## Revendications

1. Dispositif électroluminescent organique comprenant :
un premier substrat (500) comprenant une région de pixels et une région sans pixels ;
un réseau de pixels électroluminescents organiques formé au-dessus de la région de pixels du premier substrat ;
un deuxième substrat (620) placé au-dessus du premier substrat (500), le réseau étant interposé entre les premier et deuxième substrats ;
une ligne électriquement conductrice (560d) formée au-dessus de la région sans pixels du premier substrat (500) et ne recouvrant pas le réseau ; et
une couche de planarisation (570) formée au-dessus du premier substrat (500) ;
**caractérisé par** une soudure au verre fritté (630) interposée entre les premier et deuxième substrats et entourant le réseau de façon que le réseau soit encapsulé par le premier substrat (500), le deuxième substrat (620) et la soudure au verre fritté (630), où la ligne électriquement conductrice (560d) comprend une partie recouvrant la soudure au verre fritté (630) dans un segment du dispositif de façon que la partie de la ligne électriquement conductrice éclipse complètement la soudure au verre fritté (630) dans le segment lors d'une visualisation depuis le premier substrat (500) ;
dans lequel la soudure au verre fritté (630) ne vient pas au contact de la couche de planarisation (570) ;
dans lequel la soudure au verre fritté (630) a une certaine largeur, prise dans un plan en coupe transversale, et la ligne électriquement conductrice (560d) a une certaine largeur, prise dans le plan en coupe transversale, et où la largeur de la soudure au verre fritté (630) est inférieure à la largeur de la ligne électriquement conductrice (560d), et
dans lequel la soudure au verre fritté (630) se connecte à la ligne électriquement conductrice (560d) sans matériau entre elles.

2. Dispositif selon la revendication 1, où le dispositif comprend en outre au moins une couche située entre la ligne électriquement conductrice (560d) et le premier substrat (500), l'au moins une couche comprenant un matériau organique.

3. Dispositif selon l'une quelconque des revendications 1 et 2, dans lequel la ligne électriquement conductrice (560d) comprend en outre une partie qui ne recouvre pas la soudure au verre fritté (630).

4. Dispositif selon l'une quelconque des revendications 1 à 3, dans lequel la ligne électriquement conductrice (560d) s'étend le long d'un bord périphérique du premier substrat (500), et dans lequel la soudure au verre fritté (630) s'étend le long du bord périphérique du premier substrat (500).

5. Dispositif selon l'une quelconque des revendications 1 à 4, dans lequel la ligne électriquement conductrice (560d) est faite de métal.

6. Dispositif selon l'une quelconque des revendications 1 à 5, dans lequel, dans un autre segment du dispositif, la soudure au verre fritté (630) comprend en outre une partie non éclipsée qui n'est pas éclipsée par la ligne électriquement conductrice (560d) lors d'une visualisation depuis le premier substrat (500).

7. Dispositif selon l'une quelconque des revendications précédentes, dans lequel la ligne électriquement conductrice (560d) comprend une ligne d'alimentation électrique connectée électriquement au réseau.

8. Dispositif selon l'une quelconque des revendications 1 à 7, dans lequel la ligne électriquement conductrice (560d) comprend une partie recouvrant la soudure au verre fritté (630) sur tout le dispositif de façon que la partie de la ligne électriquement conductrice (560d) éclipse la soudure au verre fritté (630) lors d'une visualisation depuis le premier substrat (500).

9. Dispositif selon l'une quelconque des revendications 1 à 8, dans lequel la couche de planarisation est formée au-dessus d'au moins une partie de la région sans pixels du premier substrat (500).

10. Dispositif selon l'une quelconque des revendications 1 à 9, dans lequel la couche de planarisation est une couche de planarisation organique formée au-dessus d'au moins une partie de la région sans pixels du premier substrat (500), dans lequel la couche de planarisation comprend un évidement exposant la ligne électriquement conductrice (560d).

11. Dispositif selon l'une quelconque des revendications 1 à 10, comprenant en outre une pluralité de transistors à film mince interposés entre le premier substrat (500) et le réseau, dans lequel la ligne électriquement conductrice (560d) est faite d'un matériau utilisé dans la pluralité de transistors à film mince.

12. Dispositif selon l'une quelconque des revendications 1 à 11, dans lequel la soudure au verre fritté (630) comprend un ou plusieurs matériaux choisis dans le groupe constitué par l'oxyde de magnésium (MgO), l'oxyde de calcium (CaO), l'oxyde de baryum (BaO), l'oxyde de lithium (Li₂O), l'oxyde de sodium (Na₂O), l'oxyde de potassium (K₂O), l'oxyde de bore (B₂O₃), l'oxyde de vanadium (V₂O₅), l'oxyde de zinc (ZnO), l'oxyde de tellure (TeO₂), l'oxyde d'aluminium (Al₂O₃), le dioxyde de silicium (SiO₂), l'oxyde de plomb (PbO), l'oxyde d'étain (SnO), l'oxyde de phosphore (P₂O₅), l'oxyde de ruthénium (Ru₂O), l'oxyde de rubidium (Rb₂O), l'oxyde de rhodium (Rh₂O), l'oxyde de ferrite (Fe₂O₃), l'oxyde de cuivre (CuO), l'oxyde de titane (TiO₂), l'oxyde de tungstène (WO₃), l'oxyde de bismuth (Bi₂O₃), l'oxyde d'antimoine (Sb₂O₃), le verre de borate de plomb, le verre de phosphate d'étain, le verre de vanadate, et le borosilicate.

13. Dispositif selon l'une quelconque des revendications 1 à 12, dans lequel la couche de planarisation comprend un évidement, et dans lequel au moins une partie de la soudure au verre fritté (630) s'étend dans l'évidement.

14. Dispositif selon l'une quelconque des revendications 1 à 13, dans lequel la couche de planarisation s'étend au-dessus d'au moins une partie de la région de pixels et d'au moins une partie de la région sans pixels.

15. Dispositif selon l'une quelconque des revendications 1 à 14, dans lequel la couche de planarisation comprend un matériau organique.

16. Procédé de préparation d'un dispositif électroluminescent organique, le procédé comprenant les étapes consistant à :
disposer d'un dispositif non fini comprenant un premier substrat (500), un réseau de pixels électroluminescents organiques formés au-dessus du premier substrat (500), une ligne électriquement conductrice (560d) formée au-dessus du premier substrat (500) et ne recouvrant pas le réseau, et une couche de planarisation formée au-dessus du premier substrat (500) ;
disposer en outre d'un deuxième substrat (620) ;
interposer une fritte (630) entre les premier et deuxième substrats de façon que le réseau soit interposé entre les premier et deuxième substrats, que la fritte (630) entoure le réseau, ne vienne pas au contact de la couche de planarisation et vienne au contact de la ligne électriquement conductrice (560d), et qu'une partie de la ligne électriquement conductrice (560d) recouvre la fritte dans un segment du dispositif, où la soudure au verre fritté (630) a une certaine largeur, prise dans un plan en coupe transversale, et la ligne électriquement conductrice (560d) a une certaine largeur, prise dans le plan en coupe transversale, et où la largeur de la soudure au verre fritté (630) est inférieure à la largeur de la ligne électriquement conductrice (560d), moyennant quoi la partie de la ligne électriquement conductrice (560d) éclipse complètement la fritte (630) dans le segment lors d'une visualisation depuis le premier substrat ; et
fondre et de nouveau solidifier au moins une partie de la fritte (630) de façon à interconnecter le dispositif non fini et le deuxième substrat via la fritte, où la fritte se connecte à la ligne électriquement conductrice (560d) sans matériau entre elles, et où la fritte (630) se connecte au deuxième substrat (620) avec ou sans matériau entre eux.

17. Procédé selon la revendication 16, dans lequel l'interposition comprend la mise en contact de la fritte (630) avec la partie de la ligne électriquement conductrice (560d) et le deuxième substrat (620).

18. Procédé selon la revendication 16 ou 17, dans lequel le dispositif non fini comprend en outre la couche de planarisation qui est formée au-dessus du premier substrat (500) avec une partie d'exposition d'ouverture de la ligne électriquement conductrice (560d), et dans lequel l'interposition de la fritte (630) comprend la mise en contact de la fritte (630) avec la ligne électriquement conductrice (560d) à travers l'ouverture.

19. Procédé selon la revendication 18, dans lequel l'obtention du dispositif non fini comprend les opérations consistant à :
disposer la couche de planarisation au-dessus de la ligne électriquement conductrice (560d) ; et
graver sélectivement la couche de planarisation pour former l'ouverture avant l'interposition de la fritte (630) .

20. Procédé selon l'une quelconque des revendications 16 à 19, dans lequel la fusion comprend l'exposition à un faisceau laser ou à un rayonnement infrarouge d'au moins une partie de la fritte (630).

21. Procédé selon l'une quelconque des revendications 16 à 20, dans lequel l'interposition de la fritte comprend les étapes consistant à :
former la fritte (630) au-dessus d'au moins l'un parmi les premier et deuxième substrats ; et
disposer les premier et deuxième substrats de façon à interposer la fritte (630) entre eux.

22. Procédé selon la revendication 21, dans lequel la formation de la fritte comprend une sérigraphie ou une distribution d'un matériau de la fritte (630) au-dessus d'au moins l'un des premier et deuxième substrats.

23. Procédé selon l'une quelconque des revendications 16 à 22, dans lequel le dispositif non fini comprend en outre un ou plusieurs réseaux additionnels de pixels électroluminescents organiques et une ou plusieurs lignes électriquement conductrices additionnelles formées au-dessus du substrat ;
le procédé comprenant en outre la formation d'une ou plusieurs frittes additionnelles entre les premier et deuxième substrats de façon que chaque fritte additionnelle entoure l'un des réseaux additionnels et vienne au contact d'une partie de l'une des lignes électriquement conductrices additionnelles.

24. Procédé selon la revendication 23, dans lequel l'une des lignes électriquement conductrices additionnelles éclipse complètement la fritte additionnelle.

25. Procédé selon la revendication 23 ou 24, comprenant en outre la découpe du produit résultant de la revendication 23 en deux ou plus de deux morceaux, où l'un des morceaux comprend la fritte et le réseau interposé entre les premier et deuxième substrats.
